# EUROPEAN PATENT SPECIFICATION

(11) **EP 3 070 109 B1**
(45) Date of publication and mention of the grant of the patent: **05.12.2018**
(21) Application number: 16152914.4
(22) Date of filing: 27.01.2016
(51) Int. Cl.: C08F 220/18, C08F 222/10, C09D 133/08

(54) **MULTILAYER POLYMER COMPOSITE FOR ENCAPSULATING QUANTUM DOTS**
MEHRSCHICHTIGER POLYMERVERBUNDSTOFF ZUR EINKAPSELUNG VON QUANTENPUNKTEN
COMPOSITE DE POLYMÈRE MULTICOUCHE POUR ENCAPSULER DES POINTS QUANTIQUES

(30) Priority: 16.03.2015 US 201562133512 P
(43) Date of publication of application: 21.09.2016
(73) Proprietor: Rohm and Haas Electronic Materials LLC, Marlborough, MA 01752 (US); Rohm And Haas Electronic Materials Korea Ltd., Chungcheongnam-do 331-980 (KR); Dow Global Technologies LLC, Midland, MI 48674 (US)
(72) Inventor: BAI, Zhifeng, Midland, MI Michigan 48674 (US); JOO, Jaebum, Marlborough, MA Massachusetts 01752 (US); SUNG, In-Kyung, 331-980 Cheonan (KR); TAYLOR, James C, Marlborough, MA Massachusetts 01752 (US)
(74) Representative: Houghton, Mark Phillip

(56) References cited:
- WO-A1-2014/028677
- WO-A1-2015/013225
- US-A1- 2014 264 193

## Description

### FIELD OF THE INVENTION

The present invention relates to a process for preparing a multilayer assembly comprising an outer layer on each side of a polymer composite containing quantum dots.

### BACKGROUND OF THE INVENTION

Semiconductor quantum dots (QD) provide optical absorption and emission (photoluminescence PL or electroluminescence EL) behaviors that are significantly different from those of bulk materials. As the particle size decreases, effective energy bandgap (Eg), or available energy levels, increases and creates a blue shifted PL spectrum. This spectrum tunability by the particle size dependent quantum confinement effect within the same material is a critical advantage over conventional bulk semiconductors. Because of their unique optical properties, QD have been of great interest in many display and lighting applications. Most QD have inorganic shells with a larger bandgap material to confine electron and hole pairs within the core region and prevent any surface charge states. The outer shells are then capped by organic ligands to reduce trap states of the shell that can lead to reduced quantum yield (QY). Organic ligands help QD to disperse in organic/aqueous solvents. Typical organic ligands surrounding QD have relatively long alkyl chains which provide high solubility in non-polar solvents or monomers. Unfortunately, QD are very susceptible to photo-oxidation during light absorption/conversion process. Also, moisture can have similar impacts when ligands are not compatible. QD typically are encapsulated in a polymer matrix to protect them from adverse effects of water and oxygen. For example, US2010/0084629 discloses a variety of polymers as encapsulants. However, this reference does not disclose the polymer compositions described herein.

### SUMMARY OF THE INVENTION

The present invention provides a multilayer assembly comprising an outer layer on each side of a polymer composite, the polymer composite comprising quantum dots and polymerized units of a compound of formula (I) having one (meth)acrylate ester substituent and a compound of formula (I) having two (meth)acrylate ester substituents in a weight ratio from 100:1 to 1:5, respectively, 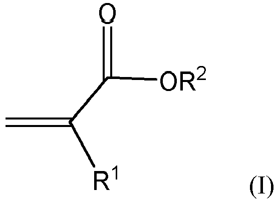 wherein R¹ is hydrogen or methyl and R² is a C₆-C₂₀ aliphatic polycyclic substituent.

### DETAILED DESCRIPTION OF THE INVENTION

Percentages are weight percentages (wt%) and temperatures are in °C, unless specified otherwise. Operations were performed at room temperature (20-25 °C), unless specified otherwise. Boiling points are measured at atmospheric pressure (ca. 101 kPa). The term "(meth)acrylate" means acrylate or methacrylate. Quantum dots are well known in the art, see, e.g., US2012/0113672 and WO2015/013225.

The polymer composite is part of a multilayer assembly which also comprises an outer layer on each side of the polymer composite. Preferably, the outer layer is an oxygen barrier which also inhibits passage of moisture. Preferably, the outer layer comprises a polymer film, preferably one comprising polyethylene terephthalate (PET), polyaryletherketones, polyimides, polyolefins, polycarbonate, polymethyl methacrylate (PMMA), polystyrene, or a combination thereof. Preferably, the outer layer further comprises oxides or nitrides, preferably silicon oxides, titanium dioxide, aluminum oxide, silicon nitrides or a combination thereof. Preferably the oxides or nitrides are coated on the surface of the polymer film facing the QD layer. Preferably, each outer layer comprises a polymer film having a thickness from 25 to 150 microns (preferably 50 to 100 microns) and an oxide/nitride layer having a thickness from 10 to 100 nm (preferably 30 to 70 nm). In some preferred embodiments of the invention, the outer layer comprises at least two polymer film layers and/or at least two oxide/nitride layers; different layers may be of differing composition. Preferably, the outer layers have a very low oxygen transmission rate (OTR, < 10⁻¹ cc/m²/day) and low water vapor transmission rate (WVTR, < 10⁻² g/m²/day). Preferably, the polymer film in the outer layers has a Tg from 60 to 200°C; preferably at least 90°C, preferably at least 100°C.

Preferably, the thickness of the polymer composite is from 10 to 500 microns, preferably at least 20 microns, preferably at least 30 microns, preferably at least 40 microns; preferably no greater than 400 microns, preferably no greater than 300 microns, preferably no greater than 200 microns, preferably no greater than 150 microns. Preferably, the thickness of each outer layer is from 20 to 100 microns, preferably from 25 to 75 microns

Preferably, the polymer composite is prepared by free radical polymerization of the resin prepared by mixing monomers, QD and other optional additives. Preferably, the resin is coated on a first outer layer prior to curing by typical methods, e.g., spin coating, slot die coating, gravure, ink jet and spray coating. Preferably, curing is initiated by exposing the resin to ultraviolet light or heat, preferably ultraviolet light, preferably in the UVA range.

Preferably, R² is a C₇-C₁₇ aliphatic polycyclic substituent, preferably R² is a C₈-C₁₅ aliphatic polycyclic substituent. Preferably, R² is a bridged polycyclic substituent; preferably a bicyclic, tricyclic or tetracyclic substituent; preferably a bicyclic or tricyclic substituent. Preferably, R² is a saturated aliphatic substituent. Preferred structures for R² include, e.g., adamantanes, bicyclo[2,2,1]alkanes, bicyclo[2,2,2]alkanes, bicyclo[2,1,1]alkanes and tricyclodecanes (e.g., tricyclo[5,2,1,0^{2,6}]decane); these structures may be substituted with alkyl, alkoxy groups, hydroxy groups or (meth)acrylate esters (i.e., the compound of formula (I) may have at least two (meth)acrylate ester substituents; preferably no more than two); preferably alkyl and alkoxy groups have from one to six carbon atoms, preferably one to four. Tricyclodecanes and bicyclo[2,2,1]alkanes are especially preferred, particularly tricyclo[5,2,1,0^{2,6}]decane, dimethanol dimethacrylate and isobornyl acrylate. The inner layer comprises polymerized units of a compound of formula (I) having one (meth)acrylate ester substituent and a compound of formula (I) having two (meth)acrylate ester substituents in a weight ratio from 10:1 to 1:2, respectively.

Preferably, the polymer composite comprises from 0.01 to 5 wt% of quantum dots, preferably at least 0.03 wt%, preferably at least 0.05 wt%; preferably no more than 4 wt%, preferably no more than 3 wt%, preferably no more than 2 wt%. Preferably, quantum dots comprise CdS, CdSe, CdTe, ZnS, ZnSe, ZnTe, HgS, HgSe, HgTe, GaN, GaP, GaAs, InP, InAs or a combination thereof.

Preferably, ligands surrounding the inorganic part of quantum dots have non-polar components. Preferred ligands include, for example, .trioctyl phosphine oxide, dodecanethiol and fatty acid salts (e.g., stearate salts, oleic acid salts).

Other additives which may be incorporated into the polymer composite include uv stabilizers, antioxidants, scattering agents to improve light extraction, and thickeners to increase viscosity (e.g., urethane acrylate oligomers). Preferred thickeners include urethane acrylates, cellulose ethers, cellulose acrylic esters, polystyrene polymers, polystyrene block copolymers, acrylic resin and polyolefin elastomers.. Preferably, polystyrene, acrylic and polyolefin thickeners have Mw from 50,000 to 400,000; preferably from 100,000 to 200,000. Preferably, cellulose ethers have Mw from 1,000 to 100,000.

Urethane acrylate oligomers can be polyester type, polyether type, polybutadiene type, or polycarprolactone type. They can have difunctional, trifunctional, hexafunctional reactivities. Viscosities of oligomers can range from 1000 to 200,000 mPa-s (1000 to 200,000 cPs) at 50C. For non-polar ligand QDs, polybutadiene types are preferred.

Preferably, the first inner layer comprises from 1 to 60 wt% urethane acrylates, preferably at least 5 wt%, preferably at least 10 wt%; preferably no more than 50 wt%, preferably no more than 40 wt%.

Preferred forms for the polymer composite include, e.g., films, beads, strips, rods, cubes and plates. The polymer composite is useful in many applications, including, e.g., displays, lighting and medical applications. Preferred display applications include public information displays, signage, televisions, monitors, mobile phones, tablets, laptops, automotive dashboards and watches.

### EXAMPLES

### SAMPLE PREPARATION FOR EXAMPLES

All samples were prepared by lamination of the resin formulations between two i-Component PET barrier films. Approximately 2mL of resin was dispensed on the bottom film and the top has applied with a gap coating bar with gap setup (0.25 - 0.30 mm (10mil - 12mil)) based on desired film thickness. Samples were cured in a Fusion UV F300S curing system with UVA 400mJ/cm², unless otherwise noted. Film thicknesses were determined by measurement of the cured films with a micrometer and then subtracting out the barrier film thickness. Photoluminescent Quantum Yield (PLQY), peak emission wavelength (PWL) and full-width half-max of the emission peak (FWHM) were measured with a Hamamatsu C9920-02G integrating sphere. Edge ingress was determined by image analysis of 2.54 cm x 2.54 cm (1"x1") samples aged on a bare backlight unit.

### EXAMPLE 1: Comparison of linear aliphatic monomers to cycloaliphatic monomers

Curing condition: UVA 400mJ/cm² x 4times

| | Formulation A | Formulation B | Formulation C | Formulation D |
|---|---|---|---|---|
| Nanoco CFQD¹ quantum dot | 0.7 | 0.7 | 0.7 | 0.7 |
| Lauryl acrylate | 35.8 | 0 | 0 | 0 |
| Isobornyl acrylate | 0 | 35.8 | 32.7 | 29.6 |
| Tricyclodecane dimethanol diacrylate | 0 | 0 | 5 | 10 |
| IRGACURE I-819 | 2.5 | 2.5 | 2.5 | 2.5 |
| Trimethylolpropane tris(3-mercaptopropionate | 4 | 4 | 4 | 4 |
| Trimethylolpropane triacrylate | 14 | 14 | 14 | 14 |
| CN996 oligomer | 42 | 42 | 40.1 | 38.2 |
| BaSO₄ | 1 | 1 | 1 | 1 |

### 1. Cadmium-free quantum dots as described in US7588828

CN996 oligomer is an aliphatic urethane acrylate oligomer, from Sartomer America.]

### Coating thickness:

| FilmID | QD display film thickness mm |
|---|---|
| FormulationA | 0.117 |
| FormulationB | 0.110 |
| FormulationC | 0.135 |
| FormulationD | 0.121 |

### Edge ingress damage after 1000Cd/m² blue BLU

| | 24Hr | 96hous | 120hr | 168hr | 336hr |
|---|---|---|---|---|---|
| FomulationA | 0.764417 | 1.276159 | | 1.727667 | 2.248431 |
| FomulationB | 0 | 0.336642 | | 0.414909 | 0.46959 |
| FormulationC | 0 | | 0.333269 | 0.382147 | 0.435117 |
| FormulationD | 0 | | 0.26699 | 0.294882 | 0.427014 |

### EXAMPLE 2: Examples of resin with antioxidant (IRGAFOS 168) and light stabilizer (TINUVIN 5100)

| | 1 | 2 | 3 |
|---|---|---|---|
| Nanoco CFQD quantum dot | 0.14 | 0.14 | 0.14 |
| Isobornyl acrylate | 46.61 | 46.11 | 45.11 |
| Tricyclodecane dimethanol diacrylate | 30 | 30 | 30 |
| IRGACURE I-819 | 1.5 | 1.5 | 1.5 |
| IRGAFOS 168 | 0 | 0.5 | 0 |
| TINUVIN 5100 | 0 | 0 | 1.5 |
| BR-641D oligomer | 17 | 17 | 17 |
| TIPURE 706 TiO₂ particle | 7.5 | 7.5 | 7.5 |

BR-641D oligomer is a polybutadiene urethane acrylate oligomer, from Dymax.]
TIPURE 706 is available from Dupont.

Curing: 400mJ/cm². Single pass

| ID | avg (µm) |
|---|---|
| 1 | 60 |
| 2 | 72 |
| 3 | 58 |

| | PLQY | QY stdev | PWL | FWHM |
|---|---|---|---|---|
| 1 | 37.77 | 1.86 | 517.95 | 57.76 |
| 2 | 42.77 | 1.17 | 518.20 | 56.55 |
| 3 | 42.53 | 0.65 | 519.68 | 55.07 |

### EXAMPLE 3:

Example of resin prepared with polymer viscosity modifier (KRATON G1650)

| | Formulation A | Formulation B |
|---|---|---|
| Nanoco CFQD™ quantum dot | 0.2 | 0.2 |
| Isobornyl acrylate | 68.5 | 58.7 |
| Tricyclodecane dimethanol diacrylate | 20 | 30 |
| IRGACURE I-819 | 1.5 | 1.5 |
| KRATON G1650 | 7.8 | 7.6 |
| Zoco 101 ZnO particle | 2 | 2 |

Zoco101 is available from Zochem.

| ID | avg (µm) |
|---|---|
| Formulation A | 39 |
| Formulation B | 22 |

| | PLQY | PWL | FWHM |
|---|---|---|---|
| Formulation A | 41.4 | 638.9 | 59.6 |
| Formulation B | 40.5 | 648.3 | 61.4 |

### EXAMPLE 4:

Examples of resin prepared with various ratios of cycloaliphatic monomers

| | 1 | 2 | 3 | 4 |
|---|---|---|---|---|
| Nanoco CFQD quantum dot | 0.05 | 0.05 | 0.05 | 0.05 |
| Isobornyl acrylate | 60.7 | 50.7 | 40.7 | 30.7 |
| Tricyclodecane dimethanol diacrylate | 20 | 30 | 40 | 50 |
| IRGACUREI-819 | 1.5 | 1.5 | 1.5 | 1.5 |
| BR-641D Oligomer | 17 | 17 | 17 | 17 |
| TIPURE 706 TiO2 particle | 0.75 | 0.75 | 0.75 | 0.75 |

| ID | avg (µm) |
|---|---|
| 1 | 132 |
| 2 | 133 |
| 3 | 107 |
| 4 | 123 |

| **Sample ID** | **AVG QY** | **STDEV QY** | **AVG PL** | **AVG FWHM** | **AVG PL RED** | **AVG FWHM RED** |
|---|---|---|---|---|---|---|
| 1 | 60.40 | 1.14 | 519.03 | 56.72 | 634.19 | 63.19 |
| 2 | 51.43 | 0.31 | 519.70 | 55.45 | 643.86 | 63.90 |
| 3 | 47.33 | 0.87 | 515.20 | 61.46 | 640.14 | 61.53 |
| 4 | 45.13 | 0.25 | 529.94 | 70.81 | 642.13 | 64.27 |

### Edge Ingress damage (mm) after storage in 60°C/90% Relative Humidity

| | 72hr | 168hr | 336hr |
|---|---|---|---|
| 1 | 1.72 | 3.17 | 5.77 |
| 2 | 1.49 | 2.33 | 3.78 |
| 3 | 0.86 | 1.50 | 2.41 |
| 4 | 0.64 | 1.10 | 1.78 |

### EXAMPLE 5:

Examples of resin prepared with small loadings of linear aliphatic monomers as compatibilizing additives

| | 7 | 9 |
|---|---|---|
| Nanoco CFQD™ quantum dot | 0.04 | 0.04 |
| Isobornyl acrylate | 53.71 | 49.73 |
| Lauryl methacrylate | 0 | 3.96 |
| Tricyclodecane dimethanol diacrylate | 19 | 19 |
| IRGACUREI-819 | 1.5 | 1.5 |
| BR-641D Oligomer | 25 | 25 |
| TIPURE 706 TiO2 particle | 0.75 | 0.75 |

| ID | avg (µm) |
|---|---|
| 7 | 53 |
| 9 | 45 |

| | PLQY | QY stdev | PWL | FWHM |
|---|---|---|---|---|
| 7 | 32.9 | 0.44 | 637.7 | 66.6 |
| 9 | 36.9 | 0.55 | 637.4 | 64.1 |

### EXAMPLE 6: Examples of resin prepared with two different quantum dot mixtures.

| | 1 |
|---|---|
| Nanoco CFQD™ green quantum dot | 0.28 |
| Nanoco CFQD™ red quantum dot | 0.07 |
| Isobornyl acrylate | 40.525 |
| Tricyclodecane dimethanol diacrylate | 30 |
| IRGACURE I-819 | 15 |
| KRATON G1652 | 9.125 |
| TINUVIN 123 | 1.5 |
| Zoco 101 ZnO particle | 3.5 |

| ID | avg (µm) |
|---|---|
| 1 | 104 |

The cured film was placed between the light guide plate and prism film/brightness enhancement film of blue LED based backlight unit (BLU). BLU spectrum was measured using GL Spectis spectroradiometer. Color coordinate of final spectrum and color gamut coverage were calculated based on the BLU spectrum and an available color filter dataset.

| | CIEx | CIEy | CIEz |
|---|---|---|---|
| BLU white | 0.251 | 0.239 | 0.510 |
| Panel blue | 0.157 | 0.057 | 0.786 |
| Panel green | 0.246 | 0.694 | 0.060 |
| Panel red | 0.677 | 0.312 | 0.011 |
| Panel white | 0.262 | 0.276 | 0.461 |

| | Color gamut coverage (vs.sRGB) |
|---|---|
| % area | 138 |
| % overlap | 100 |

Wavelength dependent emission spectrum normalized by the maximum peak intensity.

| wavelength | blue LED BLU | blue LED BLU + film |
|---|---|---|
| 400 | 0.001799541 | -0.001718333 |
| 405 | 0.005268541 | 0.000577671 |
| 410 | 0.016890786 | 0.007631886 |
| 415 | 0.04931601 | 0.028007319 |
| 420 | 0.122586966 | 0.081087041 |
| 425 | 0.265607892 | 0.199143175 |
| 430 | 0.511079238 | 0.430434011 |
| 435 | 0.833891183 | 0.774125936 |
| 440 | 1 | 0.991670706 |
| 445 | 0.864842533 | 0.898225587 |
| 450 | 0.57331293 | 0.61091274 |
| 455 | 0.339906003 | 0.363499942 |
| 460 | 0.199517423 | 0.211355149 |
| 465 | 0.11107564 | 0.117340634 |
| 470 | 0.063158431 | 0.069497716 |
| 475 | 0.037262744 | 0.047296871 |
| 480 | 0.021987463 | 0.037964307 |
| 485 | 0.012910007 | 0.038338101 |
| 490 | 0.007966666 | 0.046298448 |
| 495 | 0.005238596 | 0.061020953 |
| 500 | 0.003220408 | 0.084885063 |
| 505 | 0.002313958 | 0.120505083 |
| 510 | 0.001915676 | 0.168584908 |
| 515 | 0.001401463 | 0.225699285 |
| 520 | 0.000859068 | 0.285145182 |
| 525 | 0.000923902 | 0.335413153 |
| 530 | 0.00049007 | 0.362652675 |
| 535 | 0.00069194 | 0.36050481 |
| 540 | 0.00045016 | 0.335668494 |
| 545 | 0.000403799 | 0.293595319 |
| 550 | 7.34827E-05 | 0.244397867 |
| 555 | 0.000133896 | 0.194297165 |
| 560 | 3.49273E-05 | 0.151623188 |
| 565 | -1.87684E-05 | 0.11996641 |
| 570 | -4.49488E-05 | 0.096343986 |
| 575 | 7.58107E-05 | 0.078691345 |
| 580 | 7.31695E-05 | 0.06614026 |
| 585 | -0.000314182 | 0.057090482 |
| 590 | -0.000335826 | 0.052079524 |
| 595 | 7.39134E-05 | 0.051888975 |
| 600 | -0.000278013 | 0.05624342 |
| 605 | -0.000346791 | 0.066283223 |
| 610 | -0.000459618 | 0.083073783 |
| 615 | -0.000457154 | 0.106960422 |
| 620 | -0.000748242 | 0.13759379 |
| 625 | -0.000716673 | 0.175583563 |
| 630 | -0.000522994 | 0.215143612 |
| 635 | -0.000838996 | 0.249540865 |
| 640 | -0.000543793 | 0.274591557 |
| 645 | -0.000512196 | 0.286686784 |
| 650 | -0.000598369 | 0.287997624 |
| 655 | -0.000886423 | 0.279322187 |
| 660 | -0.000449722 | 0.261573281 |
| 665 | -0.000750665 | 0.238296318 |
| 670 | -0.00101099 | 0.210964628 |
| 675 | -0.001141071 | 0.183288842 |
| 680 | -0.001147285 | 0.157807348 |
| 685 | -0.001269858 | 0.136076083 |
| 690 | -0.001727023 | 0.116518628 |
| 695 | -0.00166393 | 0.098685064 |
| 700 | -0.001698529 | 0.0847294 |
| 705 | -0.001551849 | 0.070714339 |
| 710 | -0.00270767 | 0.057980488 |
| 715 | -0.003036792 | 0.046570789 |
| 720 | -0.004571635 | 0.036315994 |
| 725 | -0.009056433 | 0.02743212 |
| 730 | -0.009250231 | 0.017445023 |
| 735 | -0.0078037 | 0.010043558 |
| 740 | -0.007486296 | 0.00546386 |
| 745 | -0.007656289 | 0.004965795 |
| 750 | -0.00738996 | 0.00555811 |

## Claims

1. A multilayer assembly comprising an outer layer on each side of a polymer composite, the polymer composite comprising quantum dots and polymerized units of a compound of formula (I) having one (meth)acrylate ester substituent and a compound of formula (I) having two (meth)acrylate ester substituents in a weight ratio from 100:1 to 1:5, respectively, 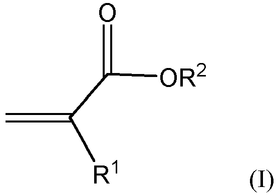 wherein R¹ is hydrogen or methyl and R² is a C₆-C₂₀ aliphatic polycyclic substituent.

2. The multilayer assembly of claim 1 in which R² is a bridged polycyclic substituent.

3. The multilayer assembly of claim 2 in which R² is a C₇-C₁₇ bridged polycyclic substituent.

4. The multilayer assembly of claim 3 in which R² has a bicyclo[2,2,1]alkane or tricyclodecane ring system.

5. The multilayer assembly of claim 4 in which the quantum dots comprise CdS, CdSe, CdTe, ZnS, ZnSe, ZnTe, HgS, HgSe, HgTe, GaN, GaP, GaAs, InP, InAs or a combination thereof.

6. The multilayer assembly of claim 5 further comprising a urethane acrylate, a cellulose ether, a cellulose acrylic ester, a polystyrene polymer, a polystyrene block copolymer, an acrylic resin or a polyolefin elastomer.

7. The multilayer assembly of claim 5 further comprising a scattering agent.

8. The multilayer assembly of claim 7 further comprising an antioxidant or UV light stabilizer.

9. The multilayer assembly of claim 5 which is a film.

## Patentansprüche

1. Eine mehrschichtige Anordnung, beinhaltend eine äußere Schicht auf jeder Seite eines Polymerverbundstoffs, wobei der Polymerverbundstoff Quantenpunkte und polymerisierte Einheiten einer Verbindung der Formel (I) mit einem (Meth)acrylatestersubstituenten und einer Verbindung der Formel (I) mit zwei (Meth)acrylatestersubstituenten in einem Gewichtsverhältnis von jeweils 100 : 1 bis 1 : 5 beinhaltet, 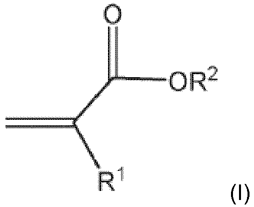 wobei R¹ Wasserstoff oder Methyl ist und R² ein aliphatischer polycyclischer C₆-C₂₀-Substituent ist.

2. Mehrschichtige Anordnung gemäß Anspruch 1, wobei R² ein verbrückter polycyclischer Substituent ist.

3. Mehrschichtige Anordnung gemäß Anspruch 2, wobei R² ein verbrückter polycyclischer C₇-C₁₇-Substituent ist.

4. Mehrschichtige Anordnung gemäß Anspruch 3, wobei R² ein Bicyclo[2,2,1]alkan- oder Tricyclodecan-Ringsystem aufweist.

5. Mehrschichtige Anordnung gemäß Anspruch 4, wobei die Quantenpunkte CdS, CdSe, CdTe, ZnS, ZnSe, ZnTe, HgS, HgSe, HgTe, GaN, GaP, GaAs, InP, InAs oder eine Kombination davon beinhalten.

6. Mehrschichtige Anordnung gemäß Anspruch 5, ferner beinhaltend ein Urethanacrylat, einen Celluloseether, einen Celluloseacrylester, ein Polystyrolpolymer, ein Polystyrolblockcopolymer, ein Acrylharz oder ein Polyolefinelastomer.

7. Mehrschichtige Anordnung gemäß Anspruch 5, ferner beinhaltend ein Streumittel.

8. Mehrschichtige Anordnung gemäß Anspruch 7, ferner beinhaltend ein Antioxidationsmittel oder einen UV-Licht-Stabilisator.

9. Mehrschichtige Anordnung gemäß Anspruch 5, bei der es sich um eine Folie handelt.

## Revendications

1. Un ensemble multicouche comprenant une couche externe sur chaque côté d'un composite à base de polymères, le composite à base de polymères comprenant des points quantiques et des unités polymérisées d'un composé de formule (I) ayant un substituant ester de (méth)acrylate et un composé de formule (I) ayant deux substituants ester de (méth)acrylate dans un rapport en poids allant de 100/1 à 1/5, respectivement, 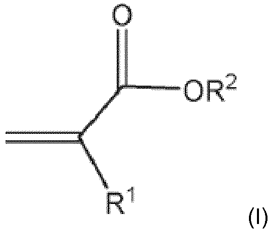 où R¹ est l'hydrogène ou un méthyle et R² est un substituant polycyclique aliphatique en C₆ à C₂₀.

2. L'ensemble multicouche de la revendication 1 dans lequel R² est un substituant polycyclique ponté.

3. L'ensemble multicouche de la revendication 2 dans lequel R² est un substituant polycyclique ponté en C₇ à C₁₇.

4. L'ensemble multicouche de la revendication 3 dans lequel R² a un système de cycle bicyclo[2,2,1]alcane ou tricyclodécane.

5. L'ensemble multicouche de la revendication 4 dans lequel les points quantiques comprennent du CdS, du CdSe, du CdTe, du ZnS, du ZnSe, du ZnTe, du HgS, du HgSe, du HgTe, du GaN, du GaP, du GaAs, du InP, du InAs ou une combinaison de ceux-ci.

6. L'ensemble multicouche de la revendication 5 comprenant en sus un acrylate d'uréthane, un éther de cellulose, un ester acrylique de cellulose, un polymère polystyrène, un copolymère séquencé polystyrène, une résine acrylique ou un élastomère de polyoléfine.

7. L'ensemble multicouche de la revendication 5 comprenant en sus un agent de diffusion.

8. L'ensemble multicouche de la revendication 7 comprenant en sus un antioxydant ou un stabilisateur à la lumière ultraviolette.

9. L'ensemble multicouche de la revendication 5 qui est un film.
